# EUROPEAN PATENT APPLICATION

(11) **EP 3 188 113 A1**
(43) Date of publication of application: **05.07.2017**
(21) Application number: 15836572.6
(22) Date of filing: 15.06.2015
(51) Int. Cl.: G06Q 50/02, A01G 7/00, G06F 17/50

(54) **PROGRAM, INFORMATION PROCESSING SYSTEM, AND INFORMATION PROCESSING METHOD**

(30) Priority: 26.08.2014 JP 2014171082
(71) Applicant: Sony Corporation, Tokyo 108-0075 (JP)
(72) Inventor: TAKEUCHI, Yuichiro, Tokyo 141-0022 (JP)
(74) Representative: Witte, Weller & Partner Patentanwälte mbB
(86) International application number: PCT/JP2015/067199
(87) International publication number: WO 2016/031354

(57) **Abstract**

To provide a program which assists a user so that an arrangement of plants arranged by the user is more appropriate. A program for causing a computer to function as: a layout acquisition unit configured to acquire arrangement information of plants arranged on a landscape by a user; a vegetation information acquisition unit configured to acquire vegetation information relating to influences exerted by the respective plants on each other; and a validity evaluation unit configured to evaluate validity of an arrangement of the plants indicated by the arrangement information, based on the vegetation information.

## Description

### Technical Field

The present disclosure relates to a program, an information processing system and an information processing method.

### Background Art

In recent years, it has become increasingly popular, in urban areas as well, to construct a natural environment such as a garden by making use of roofs or the like. When constructing such a garden, plants are usually planted in the state of nursery stocks or seeds.

Here, the growth state of flowers, branches, leaves, and roots or the like of a plant varies over time, and therefore the scene of the garden at the time of planting the plant turns out to be different from the scene of the garden at the time of completion which has been predicted by the designer of the garden. Therefore, designers of gardens or the like have been obliged to work on planting of plants, while predicting the state at the time of completion after the plants have grown.

For example, there is disclosed in Non-Patent Literature 1 a technique for predicting the branching position and extension direction of branches of a plant, as a technique for predicting, by probabilistic analysis, the variation of shape due to growth of the plant.

### Citation List

### Non-Patent Literature

Non-Patent Literature 1: Journal of Biosciences, vol. 17, no. 3. 1992. pp 275 - 291.

### Disclosure of Invention

### Technical Problem

However, the technique disclosed in Non-Patent Literature 1 is supposed to predict the growth of a single plant and therefore it has been difficult to predict the growth state of a plurality of plants, taking into account the influences exerted by respective plants on each other.

Accordingly, there has been required a technique which assists a user to realize a more appropriate arrangement of planted plants, taking into account the influences exerted by respective plants on each other, when designing a natural environment such as a garden.

Accordingly, the present disclosure proposes a new and improved program, an information processing system, and an information processing method capable of assisting a user in a manner such that the arrangement of the plants input by the user turns out to be more appropriate.

### Solution to Problem

According to the present disclosure, there is provided a program for causing a computer to function as: a layout acquisition unit configured to acquire arrangement information of plants arranged on a landscape by a user; a vegetation information acquisition unit configured to acquire vegetation information relating to influences exerted by the respective plants on each other; and a validity evaluation unit configured to evaluate validity of an arrangement of the plants indicated by the arrangement information, based on the vegetation information.

According to the present disclosure, there is provided an information processing system including: a layout acquisition unit configured to acquire arrangement information of plants arranged on a landscape by a user; a vegetation information acquisition unit configured to acquire vegetation information relating to influences exerted by the respective plants on each other; and a validity evaluation unit configured to evaluate validity of an input arrangement of the plants, based on the vegetation information.

According to the present disclosure, there is provided an information processing method including: acquiring arrangement information of plants arranged on a landscape by a user; acquiring vegetation information relating to influences exerted by the respective plants on each other; and evaluating, by an arithmetic operation processing unit, validity of an arrangement of the plants indicated by the arrangement information, based on the vegetation information.

According to the present disclosure, it is possible to evaluate the validity of an arrangement of plants by taking into account the influences exerted by respective plants on each other.

### Advantageous Effects of Invention

According to the present disclosure as described above, it is possible to assist a user so that the arrangement of the plants input by the user turns out to be more appropriate.

Note that the effects described above are not necessarily limitative. With or in the place of the above effects, there may be achieved any one of the effects described in this specification or other effects that may be grasped from this specification.

### Brief Description of Drawings

[FIG. 1] FIG. 1 is a block diagram illustrating a functional configuration of an information processing apparatus according to a first embodiment of the present disclosure.
[FIG. 2A] FIG. 2A is an explanatory diagram illustrating an exemplary input screen with an object input therein.
[FIG. 2B] FIG. 2B is an explanatory diagram illustrating an exemplary input screen with an object input therein.
[FIG. 2C] FIG. 2C is an explanatory diagram illustrating an exemplary input screen with an object input therein.
[FIG. 2D] FIG. 2D is an explanatory diagram illustrating an exemplary input screen with an object input therein.
[FIG. 3] FIG. 3 is an explanatory diagram illustrating an exemplary input screen with plants arranged on the object illustrated in FIG. 2C.
[FIG. 4] FIG. 4 is an exemplary screen display with an after-growth image of the arranged plants superimposed on the object illustrated in FIG. 3.
[FIG. 5] FIG. 5 is an exemplary screen display indicating a validity evaluation result of the plants arranged on the object illustrated in FIG. 3.
[FIG. 6] FIG. 6 is an exemplary screen display indicating modified plans of the arrangement of the plants on the object illustrated in FIG. 5.
[FIG. 7] FIG. 7 is a flowchart illustrating an exemplary operation of the information processing apparatus according to the present embodiment.
[FIG. 8] FIG. 8 is a block diagram illustrating a functional configuration of an information processing apparatus according to a second embodiment of the present disclosure.
[FIG. 9] FIG. 9 is an exemplary screen display including an image indicating planting positions of arranged seeds of the plants on the object illustrated in FIG. 3.
[FIG. 10] FIG. 10 is an explanatory diagram schematically illustrating an exemplary 3D printer head constructing an object.
[FIG. 11] FIG. 11 is an explanatory diagram schematically illustrating an exemplary 3D printer head planting seeds of a plant into the constructed object.
[FIG. 12] FIG. 12 is a block diagram illustrating a functional configuration of an information processing apparatus according to a third embodiment of the present disclosure.
[FIG. 13] FIG. 13 is an exemplary screen display including an image indicating a pipeline arrangement designed on the object illustrated in FIG. 3.
[FIG. 14] FIG. 14 is an explanatory diagram illustrating a design of the pipeline arrangement, based on the arrangement of the plants arranged on the object illustrated in FIG. 2D.
[FIG. 15] FIG. 15 is an explanatory diagram schematically illustrating a method of forming a pipeline within an object.
[FIG. 16] FIG. 16 is a block diagram illustrating a functional configuration of an information processing apparatus according to a fourth embodiment of the present disclosure.
[FIG. 17] FIG. 17 is an explanatory diagram illustrating an exemplary input screen according to the present embodiment.
[FIG. 18] FIG. 18 is a flowchart illustrating an exemplary operation of the information processing apparatus according to the present embodiment.
[FIG. 19] FIG. 19 is a block diagram illustrating a functional configuration of an information processing apparatus according to a fifth embodiment of the present disclosure.
[FIG. 20] FIG. 20 is an exemplary screen display including an image illustrating an evaluation result of an environmental evaluation unit.
[FIG. 21] FIG. 21 is a flowchart illustrating an exemplary operation of the information processing apparatus according to the present embodiment.
[FIG. 22] FIG. 22 is an explanatory diagram illustrating a hardware configuration of the information processing apparatus controlled by programs according to the first to the fifth embodiments of the present disclosure.

### Mode(s) for Carrying Out the Invention

Hereinafter, (a) preferred embodiment(s) of the present disclosure will be described in detail with reference to the appended drawings. In this specification and the appended drawings, structural elements that have substantially the same function and structure are denoted with the same reference numerals, and repeated explanation of these structural elements is omitted.

Note that description will be provided in the following order.
1. First embodiment
   1.1. Functional configuration of information processing apparatus
   1.2. Operation of information processing apparatus
2. Second embodiment
   2.1. Functional configuration of information processing apparatus
   2.2. Formation of garden designed using information processing apparatus
3. Third embodiment
   3.1. Functional configuration of information processing apparatus
4. Fourth embodiment
   4.1. Functional configuration of information processing apparatus
   4.2. Operation of information processing apparatus
5. Fifth embodiment
   5.1. Functional configuration of information processing apparatus
   5.2. Operation of information processing apparatus
6. Hardware configuration
7. Summary

### <1. First embodiment>

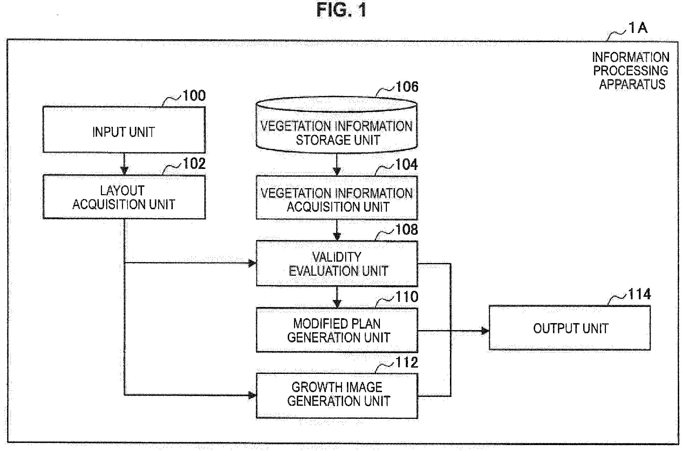

First, an information processing apparatus controlled by a program according to a first embodiment of the present disclosure will be described, referring to FIGS. 1 to 7. The program according to the present embodiment is a program which evaluates the validity of an arrangement of plants in a garden or the like input by a user, based on the influences exerted by the respective arranged plants on each other.

### [1.1. Functional configuration of information processing apparatus]

A functional configuration of the information processing apparatus controlled by the program according to the present embodiment will be described, referring to FIG. 1. FIG. 1 is a block diagram illustrating the functional configuration provided in the information processing apparatus according to the present embodiment.

As illustrated in FIG. 1, an information processing apparatus 1A includes an input unit 100, a layout acquisition unit 102, a vegetation information acquisition unit 104, a vegetation information storage unit 106, a validity evaluation unit 108, a modified plan generation unit 110, and a growth image generation unit 112.

The input unit 100 is an interface which allows a user to design a natural environment such as a garden. For example, the input unit 100 is an input screen where the user inputs the shape of a landscape such as a garden, and an arrangement of plants arranged on the landscape. The user may input an object of any shape to the input unit 100 and arrange plants on the object so as to design a garden or the like of any shape, with the object being the landscape of the garden.

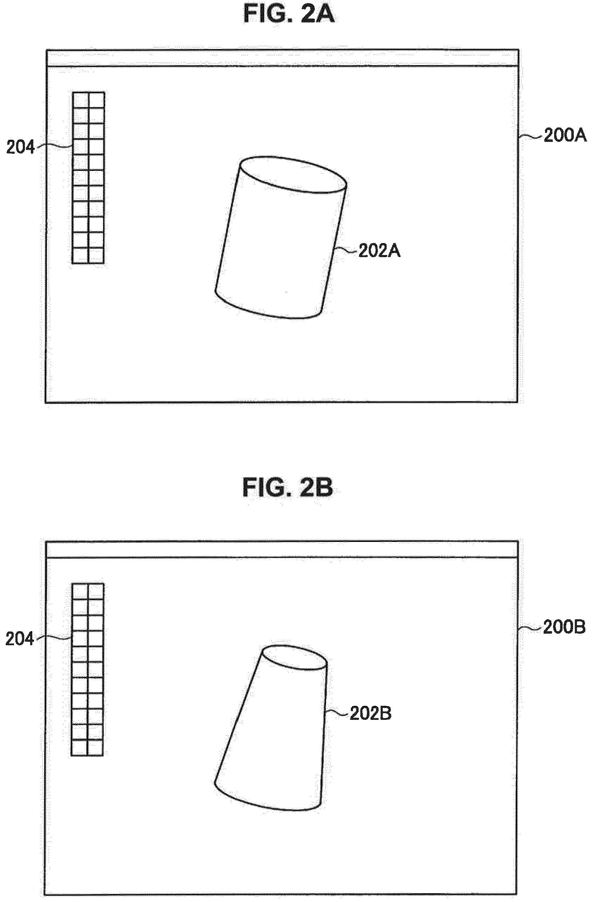

In addition, the input unit 100 includes various types of tools for assisting input of the object by the user. For example, the input unit 100 may be provided with various types of tools for assisting input of the object illustrated in FIGS. 2A to 2D. FIGS. 2A to 2D illustrate an exemplary input screens with an object input.

For example, as illustrated in FIG. 2A, an object 202A having a cylindrical shape may be input to an input screen 200A. Tools for generating such an object having a basic three-dimensional or two-dimensional shape such as a cylinder, a quadrangular prism, and a sphere are provided in an icon group 204 or the like, for example.

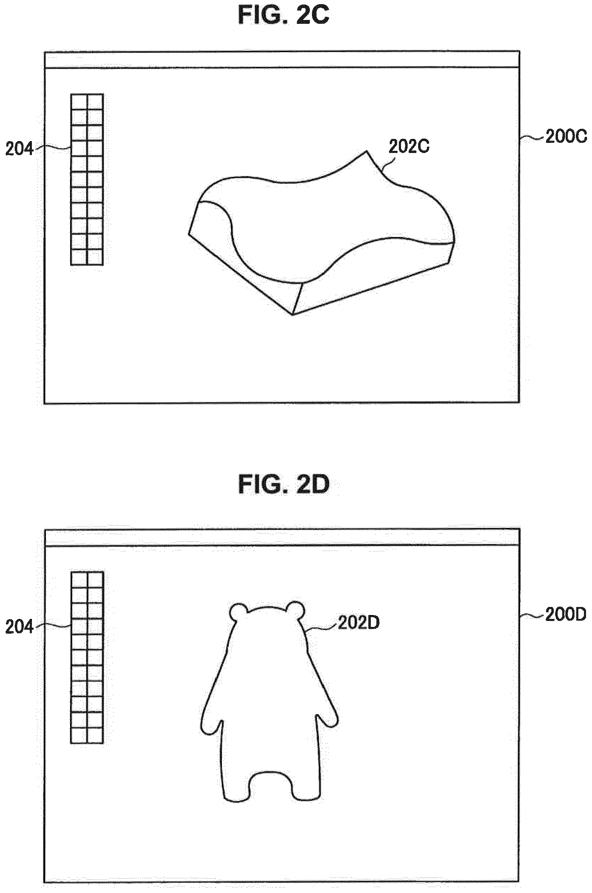

In addition, as illustrated in FIG. 2B, an object 202B having a tapering cylindrical shape (i.e., tapered) may be input to an input screen 200B. In addition, as illustrated in FIG. 2C, an object 202C having a rectangular shape with a corrugate curved surface, may also be input to an input screen 200C. Tools for transforming, expanding, enlarging, or contracting a part of such an input object are provided in the icon group 204 or the like, for example.

Furthermore, as illustrated in FIG. 2D, an object of arbitrary planar shape may be input to an input screen 200D. A tool corresponding to a pen for drawing an object having such an arbitrary planar shape is provided in the icon group 204 or the like, for example. In addition, the input screen 200D may be provided with a push-out (extrude) tool for generating a three-dimensional object having a volume in a direction perpendicular to the planar shape by pushing out the drawn planar shape.

Using the aforementioned tools provided in the icon group 204 or the like, the user may input an object having a complicated three-dimensional or two-dimensional shape and use it as the landscape shape of the garden to be designed. Note that the tools allowing the user to use in the input screen and to draw an object having a three-dimensional or two-dimensional shape are not limited to those described above, but any tools used in well-known 3D modeling software or the like are available.

Furthermore, an arrangement of plants is input by the user on the input object. For example, the types of plants arranged and the regions arranged may be indicated by displaying the surface of the object in different colors for each plant.

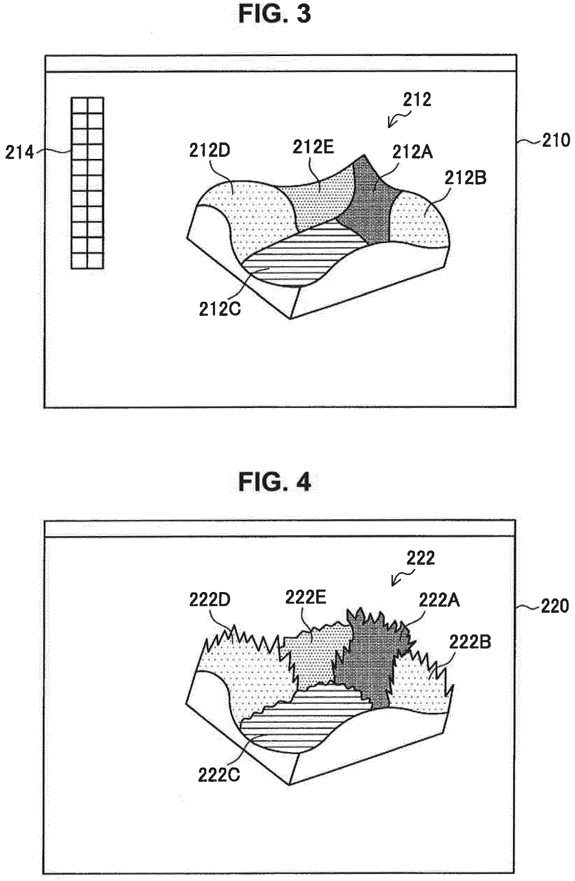

For example, as illustrated in FIG. 3, an arrangement of a plurality of types of plants is input by the user on the input object. FIG. 3 is an explanatory diagram illustrating an exemplary input screen with plants arranged on the object illustrated in FIG. 2C.

As illustrated in FIG. 3, an object 212 corresponding to the landscape shape of a garden has been input in an input screen 210. In addition, the object 212 has been displayed regions 212A, 212B, 212C, 212D and 212E indicating in different colors that different plants are arranged respectively.

For example, the user may input an arrangement of plants by specifying desired regions on the object 212 and specifying a plant to be arranged in each region. Note that the plants to be arranged are displayed in an icon group 214 in an enumerated manner, for example. The user may select a desired plant to be arranged from the icon group 214 and specify any of the regions 212A, 212B 212C, 212D and 212E of the object 212, for example, so as to arrange the selected plant on the object 212.

According to the aforementioned arrangement, the user may input an arrangement of plants on the object 212, as with the case of coloring the surface of the object 212 with a paint tool.

The layout acquisition unit 102 acquires arrangement information of the plant input by the user. Specifically, the layout acquisition unit 102 acquires the information indicating the types of a plant arranged on the object and the arrangement region. With regard to the object 212 illustrated in FIG. 3, for example, the layout acquisition unit 102 acquires information indicating the types of plants arranged on the respective regions 212A 212B, 212C, 212D and 212E on the object 212, and information indicating the positions and shapes of the respective regions 212A, 212B, 212C, 212D and 212E.

The growth image generation unit 112 generates an image indicating an after-growth state of a plant, based on arrangement information of the plant input by the user to the input unit 100. Specifically, the growth image generation unit 112 predicts, for the respective plants arranged on the object, the state after the plant has grown for a predetermined period, and generates an image with the predicted image of the plant after growth superimposed on the object. Therefore, the growth image generation unit 112 allows the user to design the garden in a manner more conforming with his/her intention, by presenting the user with a predicted image of the garden with grown plants (i.e., garden at the time of completion). Here, it is preferred to allow, by the user's instruction or the like, switching whether or not to superimpose an image of the after-growth state of a plant on the image of the object.

For example, the growth image generation unit 112 may generate a screen display 220 as illustrated in FIG. 4. FIG. 4 is an exemplary screen display with an after growth image of the arranged plants superimposed on the object illustrated in FIG. 3.

As illustrated in FIG. 4, the screen display 220 displays an object 222 with plants arranged thereon. In addition, the screen display 220 displays an after-growth state of plants in respective regions as after-growth images 222A to 222E. In other words, the screen display 220 displays the after-growth images 222A to 222E of plants in a manner superposed on the regions 212A to 212E where the plants have been arranged.

Note that there may be used a well-known simulation technique relating to plant growth, as a method of predicting the after-growth state of a plant. In addition, general images of respective plants for each growth period may be stored, and a general image of respective plants corresponding to a predictive growth period may be used to present the after-growth state. In addition, any growth period of plants may be specified by the user, such as one month, three months, or one year, for example.

The vegetation information acquisition unit 104 acquires, from the vegetation information storage unit 106, vegetation information relating to the influences exerted by respective plants on each other. For example, certain types of plants are known to have so-called allelopathy which inhibits or promotes growth of other plants or microbes by discharging chemical materials to the surrounding environment. The vegetation information acquisition unit 104 acquires information relating to the influence exerted by such a plant on other plants as vegetation information.

In addition, the vegetation information acquisition unit 104 may acquire information relating to growth conditions of respective plants from the vegetation information storage unit 106. Specifically, the vegetation information acquisition unit 104 may acquire information relating to growth conditions suitable for respective plants to grow, such as amount of sunlight, amount of water, climate, temperature, or the like.

The vegetation information storage unit 106 stores information relating to horticulture and botany, for example. Specifically, the vegetation information storage unit 106 stores information relating to the influences exerted by respective plants on each other (for example, allelopathy or the like). In addition, the vegetation information storage unit 106 may have stored therein information relating to growth conditions suitable for respective plants to grow, such as amount of sunlight, amount of water, climate, temperature, or the like.

In addition, although it is assumed in FIG. 1 that the vegetation information storage unit 106 is provided inside the information processing apparatus 1A, the technique according to the present disclosure is not limited to such an illustration. For example, the vegetation information storage unit 106 may be provided in an external storage device connected to the information processing apparatus 1A via a network or the like.

The validity evaluation unit 108 evaluates the validity of the arrangement of the plants arranged on an object, based on the vegetation information acquired by the vegetation information acquisition unit 104. Specifically, the validity evaluation unit 108 evaluates the influences exerted by the respective arranged plants on each other, and evaluates that the validity is low when the arrangement of the plants input by the user may inhibit growth of the plants.

In addition, the validity evaluation unit 108 may evaluate the validity of the arrangement of the plants arranged on the object, based on the information relating to the growth conditions of plants acquired by the vegetation information acquisition unit 104. Specifically, the validity evaluation unit 108 may evaluate that the validity of the arrangement of the plants is low when the environment of the region where the user intends to design a garden fails to satisfy the growth conditions suitable for the arranged plants to grow, such as amount of sunlight, amount of water, climate, and temperature.

Here, it is preferred that the information processing apparatus 1A has been preliminarily input information relating to the environment of the region where the user intends to set up a garden. For example, the information processing apparatus 1A may have been input climate information of the region where the user intends to set up a garden.

In addition, the information processing apparatus 1A may have been input latitude information and longitude information of the region where the user intends to set up a garden. In such a case, the information processing apparatus 1A determines the climate of a corresponding region from the latitude information and the longitude information which have been input. Note that, when information relating to the environment of the region where the user intends to set up a garden is unknown, the validity evaluation unit 108 may omit evaluating the validity of the growth conditions of plants.

Furthermore, the validity evaluation unit 108 may evaluate that the validity of the arrangement of the plants is low when the arrangement of the plants arranged on the object is an arrangement hard to grow the plants due to the structure of the object. For example, in a steeply inclined slope or a landscape where the thickness of the soil is insufficient for rooting of the plants, although the plants may be planted, the possibility for the plants to grow without dying is low. Therefore, the validity evaluation unit 108 may evaluate that the validity of the arrangement of the plants is low when the plants are arranged in a landscape hard to grow the plants.

Here, the validity evaluation unit 108 may evaluate the validity of the arrangement of the plants arranged on the object by the user, by ranking into a plurality of levels such as "○ (good)", "Δ (fair)" and "X (bad)". In addition, the validity evaluation unit 108 may evaluate the validity of the arrangement of the plants arranged on the object by the user based on scores, with 100 being the perfect score.

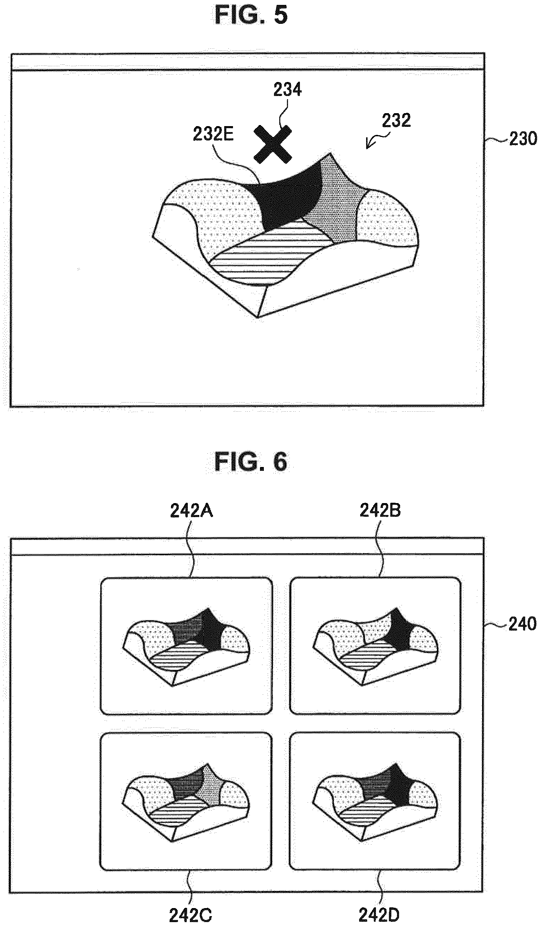

For example, as illustrated in FIG. 5, the validity evaluation unit 108 may generate a screen display indicating an evaluation result of the validity of an arrangement of plants arranged on an object, and a region with low validity. FIG. 5 is an exemplary screen display indicating a validity evaluation result of plants arranged on the object illustrated in FIG. 3.

As illustrated in FIG. 5, an object 232 with an arrangement of plants input is displayed on the screen display 230, with an "X" mark 234 as the result of the validity evaluation. Here, for example, when the validity evaluation unit 108 has evaluated that the validity of the plants arranged in a region 232E is low among the plants arranged on the object 232, the "X" mark 234 is displayed in the vicinity of the region 232E. According to the present configuration, the user may grasp the location whose validity is evaluated to be low by the validity evaluation unit 108, it is possible to modify the arrangement of the plants for higher validity.

The modified plan generation unit 110 modifies the arrangement of the plants on the object whose validity has been evaluated to be low by the validity evaluation unit 108, and generates a modified plan in which the plants are arranged according to an arrangement with higher validity. In addition, the modified plan generation unit 110 may generate a plurality of modified plans with higher validity and allow the user to select either of the modified plans to be employed.

Specifically, when any of the arranged plants is evaluated to have low validity because it suppresses (exerting allelopathy on) the growth of other plants, the modified plan generation unit 110 may generate a modified plan with improved validity by increasing the distance between the plant having allelopathy and other plants. In addition, a modified plan with improved validity may be generated by replacing the plant having allelopathy with a plant which does not have allelopathy. In such a case, it is preferred that a plant having a similar size, color and breed to those of the plant before replacement is selected as the plant after replacement.

In addition, when the validity is evaluated to be low because a plant not suited to the growth condition is included, the modified plan generation unit 110 may generate a modified plan with improved validity by replacing the plant not suited to the growth condition by a plant suited to the growth condition. In such a case, it is preferred that a plant having a similar size, color and breed to those of the plant before replacement is selected as the plant after replacement.

In addition, when the validity is evaluated to be low because there is an arrangement of a plant hard to grow due to the structure of the object, the modified plan generation unit 110 may generate a modified plan with improved validity by changing the shape of the object to a shape that allows the plant to grow. For example, the modified plan generation unit 110 may increase the thickness of the object so as to have a sufficient thickness that allows rooting of the plant, or moderate the inclination of a slope of the object so as to facilitate rooting of the plant.

For example, as illustrated in FIG. 6, the modified plan generation unit 110 may generate a screen display including a plurality of modified plans with changed arrangements of the plants arranged on the object by the user. FIG. 6 is an exemplary screen display indicating modified plans of the arrangement of the plants of the object illustrated in FIG. 5.

As illustrated in FIG. 6, modified plans 242A, 242B, 242C and 242D of the plant arrangement on the object are displayed on a screen display 240. For example, the plant arrangement of the object 232 illustrated in FIG. 5 is evaluated to have low validity for the plant arranged in the region 232E and therefore four modified plans are displayed on the screen display 240 with the plant in a region corresponding to the region 232E of FIG. 5 being changed, or the plant in a region adjacent to the region 232E being changed. Here, the user may select either of the modified plans 242A, 242B, 242C and 242D being displayed so as to modify the arrangement of the plants of the garden to an arrangement with higher validity, even when the user does not have information relating to horticulture and botany.

An output unit 114 is an interface for outputting information from the information processing apparatus 1A to the outside. For example, the output unit 114 may be a display device. In such a case, the output unit 114 displays, to the user, an image indicating the object and the plant arrangement input to the input unit 100 by the user, a prediction image after the plant has grown generated by the growth image generation unit 112, an evaluation result of the validity of the plant arrangement by the validity evaluation unit 108, and a modified plan image of the plant arrangement generated by the modified plan generation unit 110 or the like.

In addition, the information processing apparatus 1A may automatically output, to a 3D printer or the like, design information of an object designed by the user and the garden including a plant arrangement on the object. According to the configuration, the information processing apparatus 1A may use a 3D printer to automatically construct the garden designed by the user.

### [1.2. Operation of information processing apparatus]

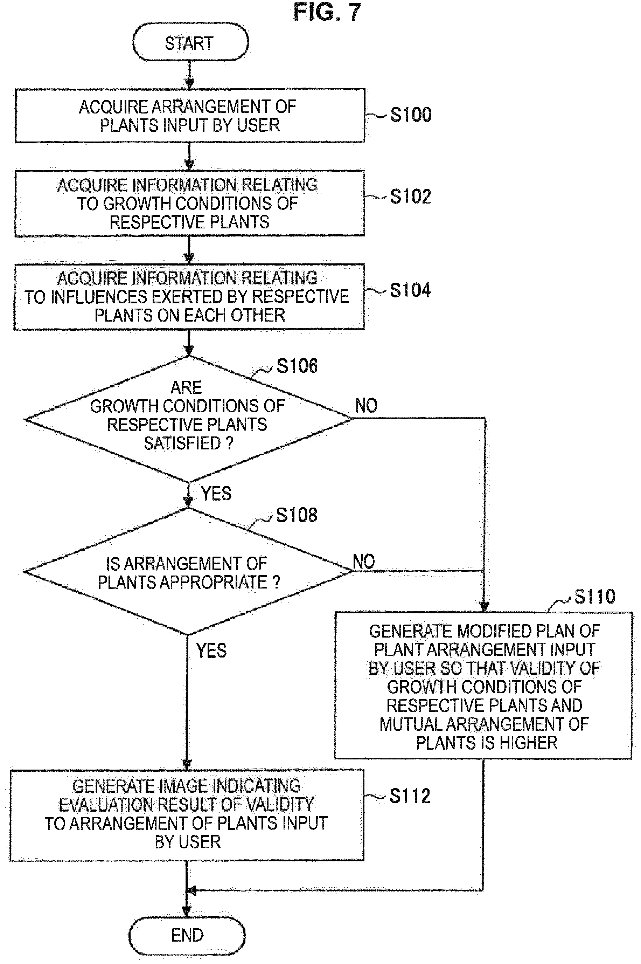

Next, an operation of the information processing apparatus 1A according to the present embodiment will be described, referring to FIG. 7. FIG. 7 is a flowchart illustrating an exemplary operation of the information processing apparatus 1A according to the present embodiment.

As illustrated in FIG. 7, the layout acquisition unit 102 first acquires arrangement information of the plant input to the input unit 100 by the user (S100). Next, the vegetation information acquisition unit 104 acquires, from the vegetation information storage unit 106, information relating to the growth conditions of the respective arranged plants (S102). In addition, the vegetation information acquisition unit 104 acquires, from the vegetation information storage unit 106, information relating to the influences exerted by the respective arranged plants on each other (for example, allelopathy) (S104).

Subsequently, the validity evaluation unit 108 evaluates whether or not growth conditions of the respective arranged plants are satisfied (S106). Here, when it is evaluated that the growth conditions of the respective arranged plants are satisfied (Yes at S106), the validity evaluation unit 108 further evaluates whether or not plants are mutually arranged appropriately without inhibiting growth of each other (S108). When it is evaluated that the mutual arrangement of the plants is appropriate (Yes at S108), the validity evaluation unit 108 generates an image notifying the user that the validity of the input arrangement of the plants is high (S 112).

When, on the other hand, it is evaluated that at least one or more of the growth conditions of the arranged plants are not satisfied (No at S106), or when it is evaluated that the plants are mutually inhibiting growth and thus the arrangement of plants is not appropriate each other (No at S108), the modified plan generation unit 110 generates a modified plan of the plant arrangement (S110).

Specifically, the modified plan generation unit 110 generates a modified plan with a plant being replaced by another plant so that the plants are satisfied with each of the growth conditions. In addition, the modified plan generation unit 110 generates a modified plan in which the inter-plant distance is increased so that the mutual arrangement of plants turns out to be appropriate, or a modified plan in which a plant is replaced by another plant. The modified plan generation unit 110 is capable of assisting the user by presenting the user with the generated modified plan so that the arrangement of the plants arranged on the object by the user turns out to be more appropriate. In addition, when there are presented a plurality of modified plans, the user may select a modified plan determined to be more preferable and employ it as the plant arrangement of the garden being designed.

As has been described above, according to the information processing apparatus 1A controlled by the program according to the present embodiment, the user may design a garden by designing an object having an arbitrary shape and arranging plants on the object. In addition, the information processing apparatus 1A is capable of assisting the user to design a garden having a plant arrangement with higher validity, by evaluating the validity of the arrangement of the plants input by the user, based on the influences exerted by respective plants on each other.

### <2. Second embodiment>

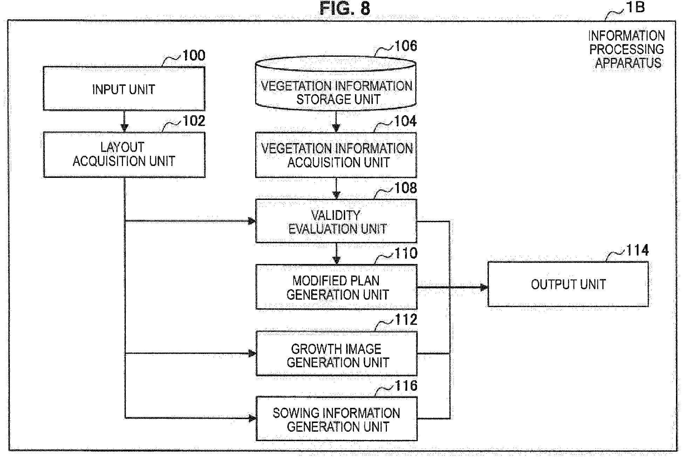

Next, description will be provided of an information processing apparatus that is controlled by a program according to a second embodiment of the present disclosure with reference to FIGS. 8 to 11. The program according to the present embodiment is a program having a function for generating sowing information indicating sowing position of seeds of plants based on arrangement information of the plants arranged on an object by a user in addition to the function according to the first embodiment.

### [2.1. Functional configuration of information processing apparatus]

Description will be provided of a functional configuration of the information processing apparatus controlled by the program according to the present embodiment with reference to FIG. 8. FIG. 8 is a block diagram illustrating the functional configuration provided for the information processing apparatus according to the present embodiment.

As illustrated in FIG. 8, an information processing apparatus 1B includes an input unit 100, a layout acquisition unit 102, a vegetation information acquisition unit 104, a vegetation information storage unit 106, a validity evaluation unit 108, a modified plan generation unit 110, a growth image generation unit 112, an output unit 114, and a sowing information generation unit 116.

Here, the input unit 100, the layout acquisition unit 102, the vegetation information acquisition unit 104, the vegetation information storage unit 106, the validity evaluation unit 108, the modified plan generation unit 110, the growth image generation unit 112, and the output unit 114 have a substantially similar configuration to the configuration according to the first embodiment, therefore, description is omitted here.

The sowing information generation unit 116 generates sowing information indicating sowing positions of the seeds of the plants based on the arrangement information of the plants input to the input unit 100 by the user. Specifically, the sowing information generation unit 116 generates information indicating at which position of the object the seeds of the plants are to be planted, relating to the plants arranged to the object.

For example, when constructing a garden with an arrangement of the plants input to the input unit 100, the user is obliged to work on planting a nursery plant or seeds based on the arrangement of the plants. However, in particular, when planting the plants in the state of the seeds, it is hard for the user who does not have knowledge and experience of the gardening to plant the seeds at appropriate interval and density. Accordingly, with the information processing apparatus 1B according to the present embodiment, the sowing information generation unit 116 automatically generates the sowing information of the plants from the arrangement information of the plants, thereby assisting the construction of the garden by the user.

Specifically, the sowing information generation unit 116 determines a position for planting the seeds of the plants for each arranged plant and generates the sowing information in consideration of a germination rate of the seeds of each plant and the density suitable for the growth of the plants. Further, when climate information of a region where the garden is set up is input, the sowing information generation unit 116 may correct the germination rate of seeds based on the climate information. The germination rate of seeds is varied depending on air temperature, humidity, or the like, therefore preferably, the sowing information generation unit 116 corrects the germination rate of seeds with the climate information, and uses the germination rate of seeds closer to the actual situation for determination of the planting positions of the seeds.

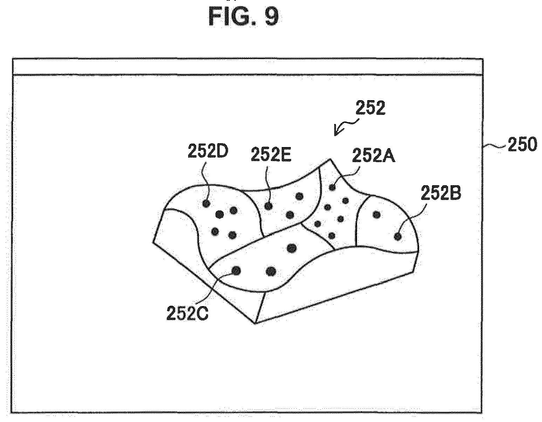

For example, the sowing information generation unit 116 may generate a screen display 250 as illustrated in FIG. 9. FIG. 9 is an exemplary screen display including an image indicating the planting positions of the arranged seeds of the plants on the object illustrated in FIG. 3.

As illustrated in FIG. 9, the screen display 250 displays an object 252 that displays the planting positions of the seeds of the plants. Further, the screen display 250 displays the planting positions of the seeds of the plants arranged in areas 212A to 212E as sowing positions 252A to 252E. The sowing information generation unit 116 determines the densities and the intervals of the sowing positions 252A to 252E in consideration of the germination rate and the optimized densities of the plants arranged to the areas 212A to 212E.

Note that, according to the present embodiment, the user may construct a landscape corresponding to the shape of the object input to the input unit 100 with manual work, or may plant the seeds at positions corresponding to the sowing positions of the seeds determined by the sowing information generation unit 116 with manual operation. Further, the seeds may be planted at the positions corresponding to the sowing positions of the seeds determined by the sowing information generation unit 116 with a pilotless drone that is wireless-operated.

### [2.2. Formation of garden designed using information processing apparatus]

According to the present embodiment, by inputting information output from the output unit 114 to a 3D printer or the like, a landscape corresponding to the shape of the object that is input to the input unit 100 may be constructed automatically and the seeds may be planted automatically at the positions corresponding to the sowing positions of the seeds determined by the sowing information generation unit 116.

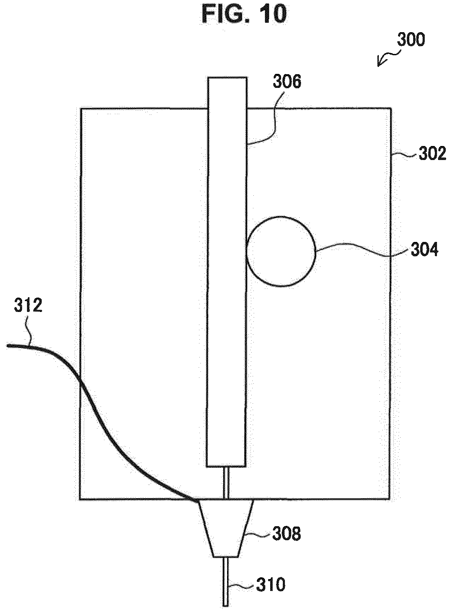

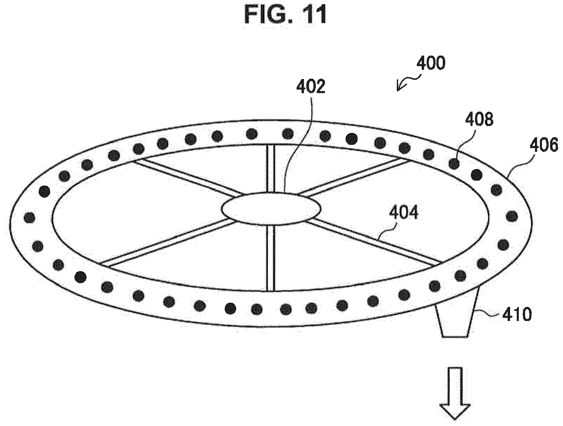

Such automatic construction of the garden can be realized by using, for example, the following 3D printer or the like that will be described with reference to FIGS. 10 and 11.

Specifically, as the head of the 3D printer, a 3D printer head illustrated in FIGS. 10 and 11 may be used, thereby forming a felt-like object with an arbitrary shape and planting the seeds at specific positions. The 3D printer to which the 3D printer head illustrated in FIGS. 10 and 11 is attached allows the 3D printer head to be moved to an arbitrary position, thereby forming the object or arranging the seeds. With the configuration, the user may automatically construct the garden where the plants are arranged on the object with an arbitrary shape.

Here, FIG. 10 is an explanatory diagram schematically illustrating an exemplary 3D printer head constructing an object where the plants are arranged. FIG. 11 is an explanatory diagram schematically illustrating an exemplary 3D printer head for planting the seeds of a plant into the constructed object.

Description will be provided of an object formation head 300 constructing the object where the plants are arranged. As illustrated in FIG. 10, the object formation head 300 includes a head member 302, a pinion gear 304, a rack 306, a yarn supply unit 308, a felt needle 310, and a yarn 312.

The head member 302 is a structure member that holds the pinion gear 304, the rack 306, and the yarn supply unit 308. Further, the rack 306 is held movably up and down with rotation of the pinion gear 304.

The pinion gear 304 is a circular gear that is fit into the rack 306. The pinion gear 304 is rotated by a stepping motor (not illustrated). The rotation of the pinion gear 304 enables the rack 306 fit into the pinion gear 304 to be moved up and down.

The rack 306 is a stick-shaped member of a flat plate from which gear teeth fit into the pinion gear 304 are cut out. The felt needle 310 is attached to one end of the rack 306. With up and down motion of the rack 306, the felt needle 310 may move up and down.

The yarn supply unit 308 is a member with a Y-shaped opening hole through which the yarn 312 and the felt needle 310 pass. The felt needle 310 and the yarn 312 pass through separate Y-shaped holes of the yarn supply unit 308, and are jointed in the yarn supply unit 308. As a result, every time when the felt needle 310 moves up and down, the yarn 312 is pulled in the felt needle 310, and is knitted as an object just under the object formation head 300.

The felt needle 310 is a needle with a plurality of barbs. The felt needle 310 pulls in the yarn 312, inserts the pulled-in yarn 312 to a lower yarn-layer (object) that is already knitted, thereby performing twisting like felt. As a result, the yarns 312 may be twisted, and are felt-like cumulated, thereby forming a felt-like object with the twisted yarn 312.

As the yarn 312, it is possible to use any long thread of a felt-like fiber as a result of twisting. Preferably, the yarn 312 is a thread formed by spinning a yarn of animal hair such as sheep wool, as a material, for example.

With the object formation head 300 illustrated in FIG. 10, it is possible to form an object with a felt-like structure by twisting the yarn 312. The felt-like structure is soft and porous, and further easily includes water, and therefore preferably may be used as a culture medium for planting the seeds of the plants.

Note that a forming method and a forming material of the object according to the present embodiment are not limited to the foregoing. For example, as a forming material of the object according to the present embodiment, it is possible to use any material that is porous and soft material, and it is further possible to use various materials such as a yarn, felt, sponge, gel, jelly, and agar. Depending on the forming material of the object, various transformation is possible without limiting the forming method of the object to the foregoing.

Next, description will be provided of a seed arrangement head 400 for planting the seeds of the plants to the object. As illustrated in FIG. 11, the seed arrangement head 400 includes a rotary mechanism 402, a spoke 404, a seed storage unit 406, seeds 408, and a seed supply unit 410.

The rotary mechanism 402 is a drive device rotatable with a rotary axis in the vertical direction. The rotary mechanism 402 may be rotated, thereby rotating the seed storage unit 406.

The spoke 404 is a structure member that connects the rotary mechanism 402 to the annular seed storage unit 406. In FIG. 11, the number of the spoke 404 is six, however, when the rotary mechanism 402 may be connected to the circular seed storage unit 406, the number of the spoke 404 is not particularly limited.

The seed storage unit 406 stores the seeds 408. The seed storage unit 406 includes small rooms each storing the seeds 408 of the respectively different plants with a specific interval in the annular structure. The seed storage unit 406 is rotated with the rotary mechanism 402 so that the small room of the seeds 408 arranged on the object is positioned to an upper portion of the seed supply unit 410.

The seeds 408 are seeds of the plants arranged on the object. Note that the seeds 408 may be subjected to chemical or physical pre-processing for easy germination of seeds.

The seed supply unit 410 falls the seeds 408 stored in the seed storage unit 406 at the upper portion, thereby arranging the seeds 408 on the object. For example, the seed supply unit 410 has an openable/closable lower cover. By opening the lower cover, the seed 408 may fall on the object with gravity.

The seed arrangement head 400 may further include a spray unit for spraying a solution that dissolves a starchy material before or after arranging the seeds 408 to the object so that the seeds 408 arranged on the object are arranged at desired positions.

Therefore, by using the 3D printer having the object formation head 300 and the seed arrangement head 400, the user may form the garden designed by the information processing apparatus 1B.

With the information processing apparatus 1B that is controlled by the program according to the present embodiment described above, information of the position for planting the seeds of the plants is generated based on the arrangement information of the plants arranged to the object. As a result, the user may grasp a place for planting the seeds of the plants arranged to the object without knowledge of horticulture or botany.

According to the present embodiment, the information from the information processing apparatus 1B may be input to the 3D printer or the like, thereby automatically forming the object and arranging the seeds to the object to automatically form the garden designed by the user.

### <3. Third embodiment>

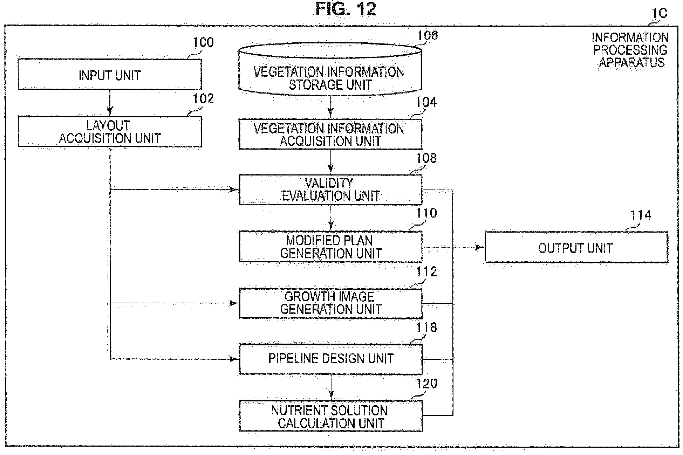

Subsequently, description will be provided of an information processing apparatus controlled by a program according to a third embodiment of the present disclosure with reference to FIGS. 12 to 15. The program according to the present embodiment is a program having a function for designing a pipeline arrangement that supplies water and nutrition required for the growth of the plants based on the arrangement information of the plants arranged on the object by the user in addition to the function according to the first embodiment.

### [3.1. Functional configuration of information processing apparatus]

Description will be provided of a functional configuration of the information processing apparatus controlled by the program according to the present embodiment with reference to FIG. 12. FIG. 12 is a block diagram illustrating the functional configuration of the information processing apparatus according to the present embodiment.

As illustrated in FIG. 12, an information processing apparatus 1C includes an input unit 100, a layout acquisition unit 102, a vegetation information acquisition unit 104, a vegetation information storage unit 106, a validity evaluation unit 108, a modified plan generation unit 110, a growth image generation unit 112, an output unit 114, a pipeline design unit 118, and a nutrient solution calculation unit 120.

Here, the input unit 100, the layout acquisition unit 102, the vegetation information acquisition unit 104, the vegetation information storage unit 106, the validity evaluation unit 108, the modified plan generation unit 110, the growth image generation unit 112, and the output unit 114 have substantially the similar configuration to the configuration described above according to the first embodiment. Accordingly, description thereof is omitted here.

The pipeline design unit 118 designs the pipeline arrangement that supplies the water and nutrition required for the growth of the plants on the object based on the arrangement information of the plants input to the input unit 100 by the user.

For example, in the case of designing a garden where plants are arranged on a complicated three-dimensional-shaped object, water might not be spread to the whole garden only by watering from an upper portion of the garden. Accordingly, with the information processing apparatus 1C according to the present embodiment, the pipeline design unit 118 designs the pipeline arrangement optimized to supply water or the like based on the arrangement information of the plants. As a result, the information processing apparatus 1C according to the present embodiment may assist appropriate growth of the plants arranged to the object to the user.

Specifically, the pipeline design unit 118 designs an arrangement, a branching, and a pipe diameter of the pipeline so as to optimally distribute the water supplied to the pipeline to the plants based on the amount of water and the amount of nutrition required for the arranged plants. Further, the pipeline design unit 118 designs a supply port for evenly supplying the water supplied to the pipeline to the object as a culture medium at the end or in the middle of the pipeline, and further designs at least one water pouring port to which the user pours the water to an uppermost part.

The pipeline design unit 118 may design a tray (pool) for pooling the water supplied to the pipeline just under an opening. The water pooled to the tray (pool) is absorbed by a peripheral culture medium or plant with capillarity or the like. Accordingly, by designing the tray, the water may be evenly supplied to even a region in the object where it is easily dried.

Further, when the object is not strong in structure, the pipeline design unit 118 may design a pipeline so as to be a frame that supports a structure of the object as a culture medium of the garden.

The nutrient solution calculation unit 120 calculates the amount of water and the amount of nutrition that are poured to the pipeline designed by the pipeline design unit 118 based on the arrangement information of the plants arranged to the object. With the configuration, the user pours a designated amount and frequency of the water and nutrition instructed from the nutrient solution calculation unit 120 to the pipeline, and the plants may thus appropriately be grown.

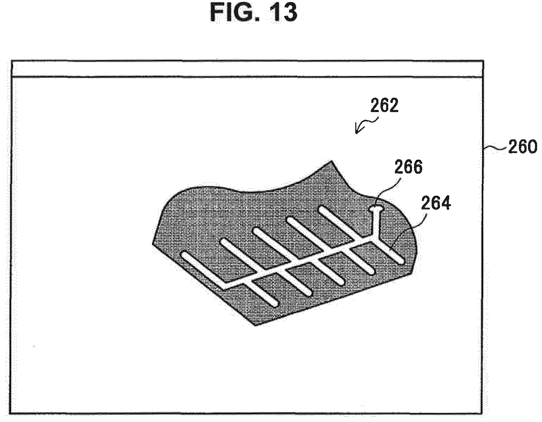

For example, the pipeline design unit 118 may generate a screen display 260 illustrated in FIG. 13. FIG. 13 is an exemplary screen display including an image indicating the designed pipeline arrangement on the object illustrated in FIG. 3.

As illustrated in FIG. 13, the screen display 260 displays a pipeline 264 arranged in an object 262. Further, in the screen display 260, the pipeline 264 includes a water pouring port 266 with a ctenidium-like branching shape on both sides. The water and nutrition are poured from the water pouring port 266, and thereby such a pipeline 264 supplies the water and nutrition to the whole object 262.

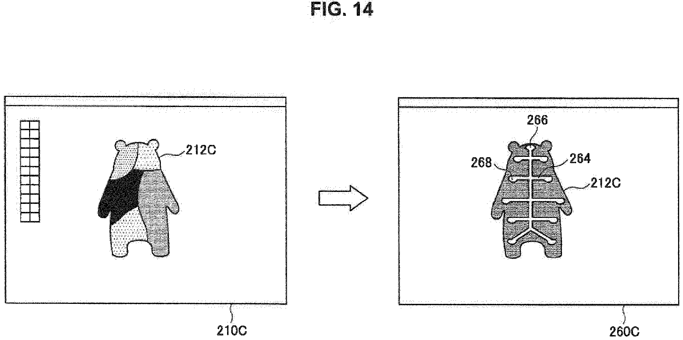

Further, the pipeline design unit 118C may generate a screen display 260C as illustrated in FIG. 14. FIG. 14 is an explanatory diagram illustrating the design of the pipeline arrangement, based on the arrangement of the plants arranged on the object illustrated in FIG. 2D.

As illustrated in FIG. 14, the screen display 210C displays the arrangement of the plants arranged on an object 212C with a complicated shape. In the case of designing the pipeline 264 based on the arrangement of the plants on the object 212C with the complicated shape, as illustrated in the screen display 260C, preferably, a pool 268 for pooling the poured water is formed. As a result, since the water and nutrition poured from the water pouring port 266 are pooled in the pool 268 at the end of the pipeline 264, the object 212C may gradually absorb the water and nutrition from the pool 268.

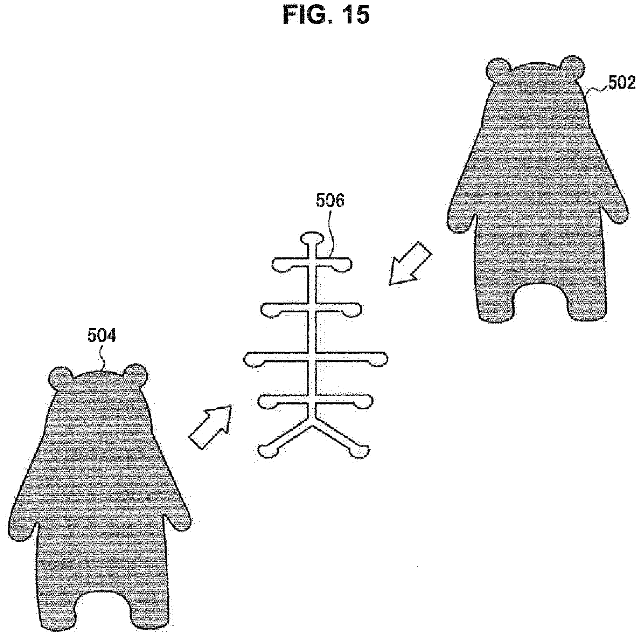

Further, as illustrated in FIG. 14, as a method of forming the pipeline 264 in the complicated object, after separately forming the pipeline and the object as illustrated in FIG. 15, a method of combining them respectively may be used. FIG. 15 is an explanatory diagram schematically illustrating the method of forming the pipeline in the object.

As illustrated in FIG. 15, object pieces 502 and 504 are first formed respectively by cutting the object designed by the information processing apparatus 1C in the thickness direction. Next, a pipeline 506 designed by the information processing apparatus 1C is formed. Subsequently, the pipeline 506 is sandwiched and pasted by the object pieces 502 and 504, thereby enabling the formation of the object including the pipeline 506 inside.

Note that, preferably, the above-mentioned pipeline is made of a material such as plastic that prevents the transmission of water. Further, in the case of using the pipeline as a frame of the object, preferably, the pipeline is made of a material such as metal with high strength.

With the information processing apparatus 1C controlled by the program according to the present embodiment as mentioned above, it is possible to design the pipeline arrangement that supplies the water and nutrition required for the growth of the plants based on the arrangement information of the plants arranged to the object. Accordingly, the user may appropriately grow the plants arranged to the object without the knowledge of horticulture or botany.

### <4. Fourth embodiment>

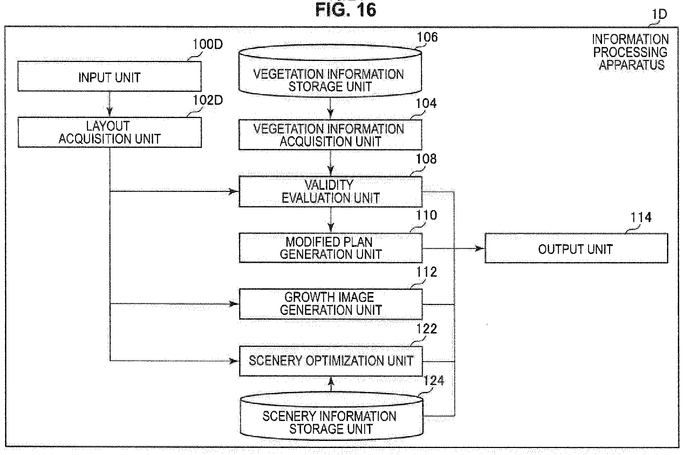

Next, description will be provided of an information processing apparatus controlled by a program according to a fourth embodiment of the present disclosure with reference to FIGS 16 to 18. The program according to the present embodiment is a program having a function for assisting the user so as to optimize the arrangement of scenery elements arranged on the object by the user in addition to the function according to the first embodiment.

### [4.1. Functional configuration of information processing apparatus]

Description will be provided of a functional configuration of the information processing apparatus controlled by the program according to the present embodiment with reference to FIG. 16. FIG. 16 is a block diagram illustrating the functional configuration of the information processing apparatus according to the present embodiment.

As illustrated in FIG. 16, an information processing apparatus 1D includes an input unit 100D, a layout acquisition unit 102D, a vegetation information acquisition unit 104, a vegetation information storage unit 106, a validity evaluation unit 108, a modified plan generation unit 110, a growth image generation unit 112, an output unit 114, a scenery optimization unit 122, and a scenery information storage unit 124.

Here, configurations of the vegetation information acquisition unit 104, the vegetation information storage unit 106, the validity evaluation unit 108, the modified plan generation unit 110, the growth image generation unit 112, and the output unit 114 are substantially similar to the configuration described according to the first embodiment, and thus description thereof is omitted here.

As described according to the first embodiment, the input unit 100D is an interface for designing nature environment such as a garden by the user. According to the fourth embodiment, an arrangement of the scenery elements constructing a scenery of the garden is input to the input unit 100D in addition to the shape of the landscape of the garden or the like and the arrangement of the plants arranged on the landscape.

The scenery element is an inorganic object, a water source, an artificial object or the like constructing the scenery other than the plants. For example, the scenery element is an inorganic object such as a stone, a rock and a mountain; a water source such as a river and a pond; or an artificial object such as a bridge, a hut, a bench and bars.

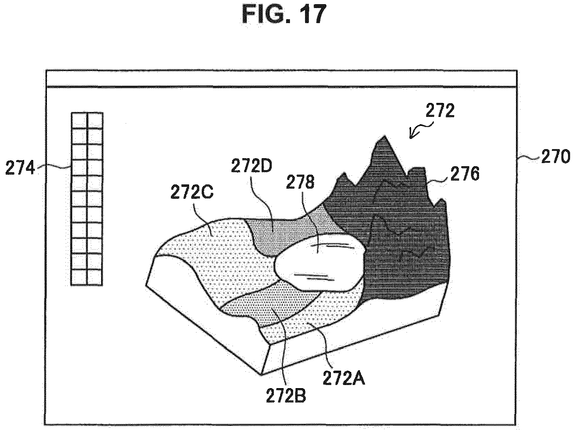

With such an input unit 100D, the user may design a garden having a more complicated scenery. For example, on an input screen illustrated in FIG. 17, the shape of an object, the arrangement of the plants arranged on the object, and the arrangement of the scenery elements arranged on the object may be input to the input unit 100D. FIG. 17 is an explanatory diagram illustrating an exemplary input screen according to the present embodiment.

As illustrated in FIG. 17, an input screen 270 displays an object 272 where the plants and the scenery elements are arranged. Specifically, the arrangement of the plants is input to regions 272A, 272B, 272C, and 272D on the object, and the types of the arranged plants is distinguished by color. Further, the arrangement of the scenery elements such as a rock 276 and a pond 278 is input onto the object 272. Note that the scenery elements arranged on the object 272 may be displayed in an icon group 274 in an enumerated manner, for example. The user selects the scenery elements to be arranged from the icon group 274, and designates an arbitrary position of the object 272, thereby enabling the arrangement of the selected scenery element onto the object 272.

As described according to the first embodiment, the layout acquisition unit 102D acquires the arrangement information of the plants input by the user. Further, according to the fourth embodiment, the layout acquisition unit 102D acquires information indicating the types and the arrangement place of the scenery elements arranged on the object in addition to information indicating the types and the arrangement region of the plants arranged on the object.

The scenery information storage unit 124 may store the arrangement information of the scenery elements in the garden evaluated as an excellent scenery. Further, the scenery information storage unit 124 may store the arrangement information of a characteristic scenery element that a typical garden style (e.g., a Saracenic garden, an English garden, a Japanese garden or the like) includes, as a garden sample.

Note that, in FIG. 16, the scenery information storage unit 124 is included in the information processing apparatus 1D. However, the technique according to the present disclosure is not limited to such an illustration. For example, the scenery information storage unit 124 may be provided in an external storage device connected to the information processing apparatus 1D via a network or the like.

The scenery optimization unit 122 performs processing for assisting the user to optimize the arrangement of the scenery elements based on the information stored in the scenery information storage unit 124. Specifically, the scenery optimization unit 122 may evaluate the arrangement of the scenery elements arranged by the user based on the arrangement of the scenery elements in the garden with the excellent scenery. Further, the scenery optimization unit 122 may automatically change the arrangement of the scenery elements arranged by the user so as to be close to the arrangement of the scenery elements in the garden with the excellent scenery, and may suggest changing the arrangement of the scenery elements to the user. Furthermore, the scenery optimization unit 122 may present a modified plan in which the arrangement of the scenery elements is changed so as to be close to the arrangement of the scenery elements in the garden with the excellent scenery. Moreover, the scenery optimization unit 122 may present the garden sample stored in the scenery information storage unit 124 to the user.

### [4.2. Operation of information processing apparatus]

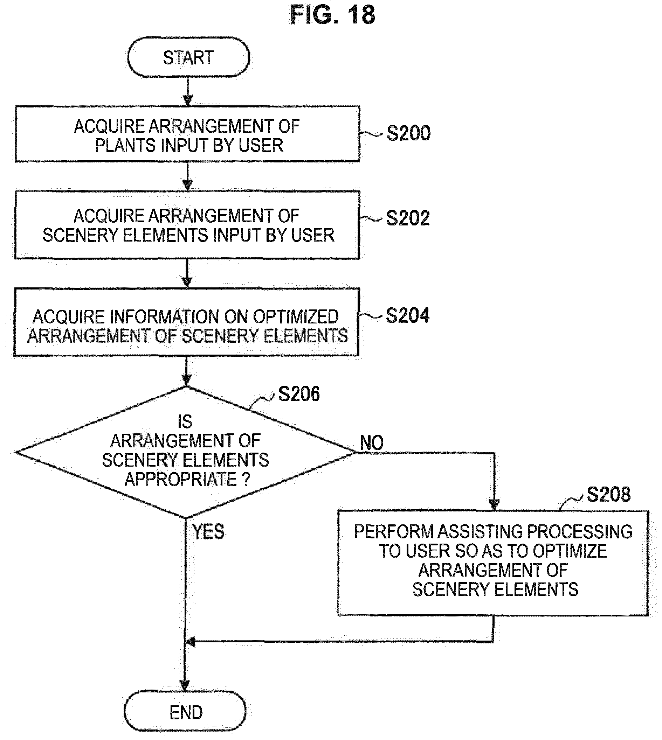

Next, description will be provided of the operation of the information processing apparatus 1D according to the present embodiment with reference to FIG. 18. FIG. 18 is a flowchart illustrating an exemplary operation of the information processing apparatus 1D according to the present embodiment.

As illustrated in FIG. 18, first of all, the layout acquisition unit 102D acquires the arrangement information of the plants input to the input unit 100D by the user (S200). Further, the layout acquisition unit 102D acquires the arrangement information of the scenery elements input to the input unit 100D by the user (S202). Subsequently, the scenery optimization unit 122 acquires the information on an optimal arrangement of the scenery elements from the scenery information storage unit 124 (S204).

Here, the scenery optimization unit 122 evaluates whether or not the arrangement of the scenery elements arranged by the user is appropriate (S206). When the arrangement of the scenery elements is appropriate (S206/Yes), the scenery optimization unit 122 presents an evaluation result to the user, and ends the operation. On the other hand, when the arrangement of the scenery elements is not appropriate (S206/No), the scenery optimization unit 122 performs assisting processing such as suggestion of the change of the arrangement of the scenery elements, optimization of the arrangement of the scenery elements, or presentation of the modified plan of the arrangement of the scenery elements (S208) to the user.

With the information processing apparatus 1D controlled by the program according to the present embodiment as mentioned above, the user may design a general garden in which the plants and the scenery elements are arranged on the object with an arbitrary shape. For example, with the information processing apparatus 1D, the user may design the whole Japanese garden including a pond, a rock, a bridge or the like. Further, by using the 3D printing technique, the user may form the garden in which the plants and the scenery elements are arranged, designed by the information processing apparatus 1D.

### <5. Fifth embodiment>

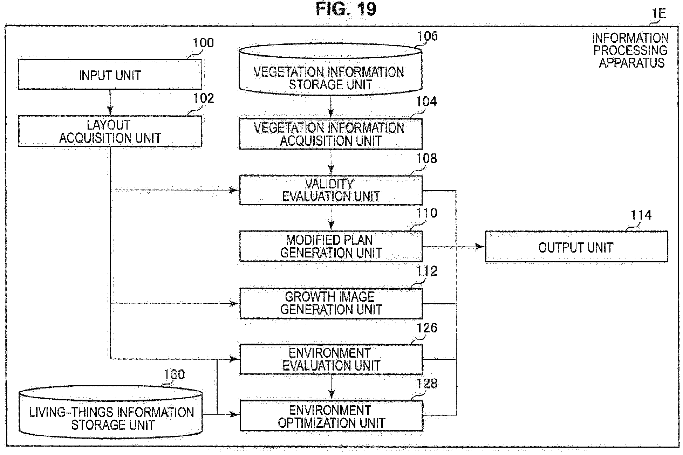

Subsequently, description will be provided of an information processing apparatus controlled by a program according to a fifth embodiment of the present disclosure with reference to FIGS. 19 to 21. The program according to the present embodiment is a program having a function for assisting the user so that environment of the object where plants are arranged is suitable for survival of specific living things based on the arrangement information of the plants arranged on the object in addition to the function according to the first embodiment.

### [5.1. Functional configuration of information processing apparatus]

First, description will be provided of a functional configuration of the information processing apparatus controlled by the program according to the present embodiment with reference to FIG. 19. FIG. 19 is a block diagram illustrating the functional configuration that the information processing apparatus includes according to the present embodiment.

As illustrated in FIG. 19, an information processing apparatus 1E includes an input unit 100, a layout acquisition unit 102, a vegetation information acquisition unit 104, a vegetation information storage unit 106, a validity evaluation unit 108, a modified plan generation unit 110, a growth image generation unit 112, an output unit 114, an environmental evaluation unit 126, an environment optimization unit 128, and a living-things information storage unit 130.

Here, the input unit 100, the layout acquisition unit 102, the vegetation information acquisition unit 104, the vegetation information storage unit 106, the validity evaluation unit 108, the modified plan generation unit 110, the growth image generation unit 112, and the output unit 114 have a substantially similar configuration to the configuration described according to the first embodiment. Thus, description thereof is omitted here.

The living-things information storage unit 130 stores a required condition of the suitable environment for survival of a specific living thing. For example, when the specific living thing is a "firefly", the living-things information storage unit 130 stores a condition required for a hatch place of the firefly, a condition required for formation of a propagation environment for waterweed, diatom, moss, or the like suitable for survival of the firefly, and a condition required for propagation of living things as a feed for a larva.

Note that the specific living thing is not limited to the "firefly" illustrated by the example above. For example, the specific living thing may be animals such as a deer and a squirrel, birds such as a migrant bird, insects such as a butterfly and a dragonfly, or fishes such as a Japanese killifish and a Japanese trout. Further, the living-things information storage unit 130 may store a condition required for a suitable environment for survival of each of a plurality of living things.

Note that, in FIG. 19, the living-things information storage unit 130 is included in the information processing apparatus 1E. However, the technique of the present disclosure is not limited to the example. For example, the living-things information storage unit 130 may be arranged in an external storage device connected to the information processing apparatus 1E via a network or the like.

The environmental evaluation unit 126 evaluates whether or not the environment on the object is suitable for the survival of the specific living thing based on the information stored in the living-things information storage unit 130. For example, the environmental evaluation unit 126 determines whether or not the environment on the object satisfies the condition required for a preferable environment for the survival of the specific living thing stored in the living-things information storage unit 130. Further, the environmental evaluation unit 126 may evaluate a suitableness (the degree of suitableness) at which the environment on the object is suitable for the survival of the specific living thing based on a number and a degree of the required conditions of the preferable environment for the specific living thing, satisfied by the environment on the object. Note that, with user selection, the specific living thing as to whether or not the environment is suitable for the survival may be changed.

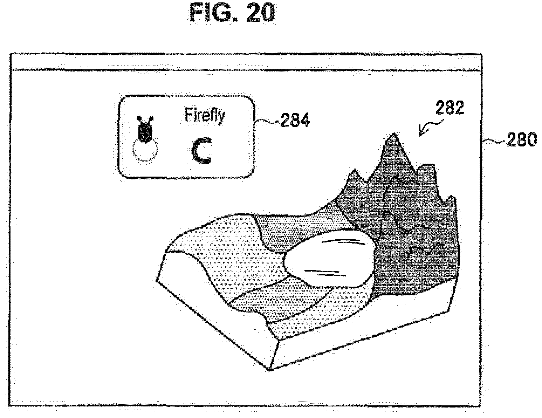

For example, the environmental evaluation unit 126 may generate a screen display 280 illustrated in FIG. 20. FIG. 20 is an exemplary screen display including an image illustrating an evaluation result of the environmental evaluation unit 126.

As illustrated in FIG. 20, an object 282 is displayed on the screen display 280, and the suitableness for the survival of the specific living thing to the environment on the object 282 is displayed in an evaluation result 284. Specifically, the specific living thing is the firefly on the screen display 280. Further, the evaluation result 284 displays that the environment on the object 282 is 'C' (e.g., in three-rank ABC evaluation) to the survival of the firefly.

The suitableness for the survival of the specific living thing to the environment on the object 282 displayed by the evaluation result 284 may be evaluated by ranking of 'A', 'B', and 'C', or '○', 'Δ', and 'x', or the like, or may be evaluated by pointing with 100 points as a perfect point or the like.

The environment optimization unit 128 performs processing for assisting the user so that the environment on the object is a more suitable environment for the survival of the specific living thing based on the information stored in the living-things information storage unit 130. Specifically, the environment optimization unit 128 may promote the change of the arrangement of plants arranged on the object by presenting the condition required for the preferable environment to the specific living thing stored in the living-things information storage unit 130 to the user. Further, the environment optimization unit 128 may optimize the arrangement of the plants arranged on the object to be suitable for the survival of the specific living thing based on the condition required for the preferable environment to the specific living thing stored in the living-things information storage unit 130.

Here, in the case where the information processing apparatus 1E includes a scenery design function according to the fourth embodiment (i.e., a case of combining the fourth embodiment and the fifth embodiment), the environment optimization unit 128 may optimize the arrangement of the scenery elements so as to be a preferable environment to the specific living thing, or may promote the change of the arrangement of the scenery elements to the user.

### [5.2. Operation of information processing apparatus]

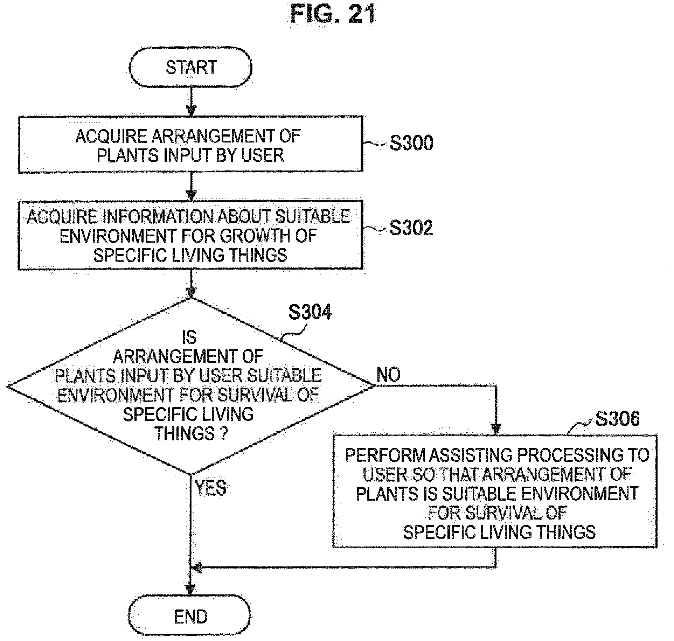

Next, description will be provided of an operation of the information processing apparatus 1E according to the present embodiment with reference to FIG. 21. FIG. 21 is a flowchart illustrating an exemplary operation of the information processing apparatus 1E according to the present embodiment.

As illustrated in FIG. 21, first, the layout acquisition unit 102 acquires the arrangement information of the plants input to the input unit 100 by the user (S300). Subsequently, the environmental evaluation unit 126 acquires information about the suitable environment for the growth of the specific living thing from the living-things information storage unit 130 (S302).

Here, the environmental evaluation unit 126 evaluates whether or not the arrangement of the plants arranged on the object is sufficiently suitable for the survival of the specific living thing (S304). When the arrangement of the plants arranged on the object is sufficiently suitable for the survival of the specific living thing (S304/ Yes), the environmental evaluation unit 126 shows an evaluation result to the user, and ends the operation.

On the other hand, when the arrangement of the plants arranged on the object is not sufficiently suitable for the survival of the specific living thing (S304/No), the environment optimization unit 128 performs assisting processing such as a suggestion of the arrangement change of the arranged plants, optimization of the arrangement of the plants, or presentation of the condition required for the suitable environment for the survival of the specific living thing to the user so that the arrangement of the plants arranged on the object is a sufficiently suitable arrangement for the survival of the specific living thing (S306).

Note that, as mentioned above, when the information processing apparatus 1E includes the scenery design function according to the fourth embodiment (that is, the case of combining the fourth embodiment and the fifth embodiment), obviously, the environment optimization unit 128 may perform the assisting processing to the arrangement of the scenery elements similar to that to the arrangement of the plants.

With the information processing apparatus 1E controlled by the program according to the present embodiment mentioned above, the user may design the garden so that the environment designed on the object is an environment suitable for the survival of the specific living thing. Accordingly, the user may design a garden which is closer to a natural environment and is capable of calling various living things.

### <6. Hardware configuration >

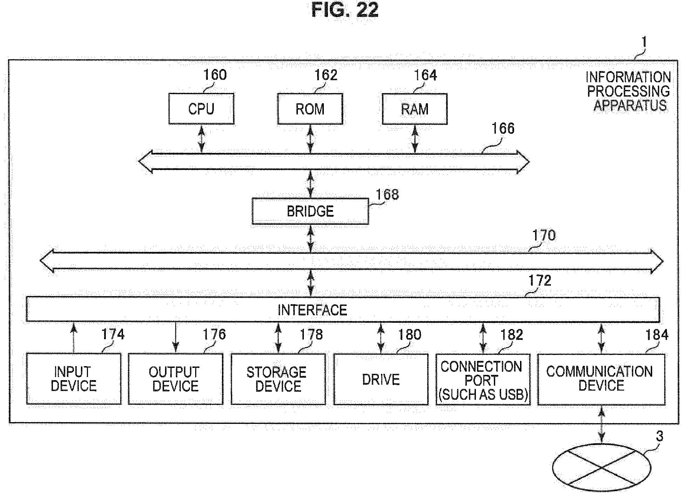

Next, description will be provided of a hardware configuration of the information processing apparatus 1 controlled by the programs according to each embodiment of the present disclosure with reference to FIG. 22. FIG. 22 is an explanatory diagram illustrating a hardware configuration of the information processing apparatus 1 controlled by the programs according to each embodiment. That is, the information processing according to each embodiment of the present disclosure is realized in cooperation with the software and the hardware that the information processing apparatus 1 includes.

As illustrated in FIG. 22, the information processing apparatus 1 includes a central progressing unit (CPU) 160, a read only memory (ROM) 162, a random access memory (RAM) 164, a bridge 168; internal buses 166 and 170, an interface 172, an input device 174, an output device 176, a storage device 178, a drive 180, a connection port 182, and a communication device 184.

The CPU 160 functions as an arithmetic operation processing device and a control device, and controls the whole operations in the information processing apparatus 1 under the program according to the present embodiment. The ROM 162 stores a program and an arithmetic operation parameter used by the CPU 160. The RAM 164 temporarily stores a program used in execution of the CPU 160, a parameter which appropriately changes in the execution, or the like. The CPU 160 executes functions of, e.g., the layout acquisition unit 102, the vegetation information acquisition unit 104, the validity evaluation unit 108, the modified plan generation unit 110, the growth image generation unit 112, the sowing information generation unit 116, the pipeline design unit 118, the nutrient solution calculation unit 120, the scenery optimization unit 122, the environmental evaluation unit 126, the environment optimization unit 128, or the like.

The CPU 160, the ROM 162, and the RAM 164 are mutually connected by the bridge 168, the internal buses 166 and 170, or the like. Further, the CPU 160, the ROM 162, and the RAM 164 are also mutually connected to the input device 174, the output device 176, the storage device 178, the drive 180, the connection port 182, and the communication device 184 via the interface 172.

The input device 174 includes an input device for user's input of information, such as a mouse, a keyboard, a button, a microphone, a switch, or a lever, and an input control circuit that generates an input signal based on the user's input and outputs the signal to the CPU 160. The input device 174 executes, e.g., the function of the input unit 100.

The output device 176 includes, e.g., a liquid crystal display (LCD) device, an organic electroluminescence display (OLED) device, a plasma display device, a cathode ray tube (CRT) device, and a display device such as a lump. Further, the output device 176 may include a sound output device such as a speaker and a headphone. For example, the display device displays a photographed image or a generated image. On the other hand, the sound output device converts sound data or the like into sound and outputs the sound. The output device 176 executes, e.g., the function of the output unit 114.

The storage device 178 is a device for data storage constructed as an exemplary storage unit of the information processing apparatus 1. The storage device 178 may include a storage medium, a storage device that stores data to the storage medium, a read device that reads data from the storage medium, and a deletion device that deletes the stored data. The storage device 178 executes the functions of, e.g., the vegetation information storage unit 106, the scenery information storage unit 124, the living-things information storage unit 130, or the like.

The device 180 is a reader/writer for the storage medium, and is included in or externally attached to the information processing apparatus 1. The drive 180 reads information stored in a loaded removable storage medium such as a magnetic disk, an optical disk, a magneto-optical disk, or a semiconductor memory, and outputs the read information to the RAM 164. Further, the drive 180 may write information to the removable storage medium.

The connection port 182 is a connection interface constructed by a connection port for connecting an external connection device such as a universal serial bus (USB) port, an optical audio terminal, or the like.

The communication device 184 is a communication interface constructed by a communication device or the like for being connected to the network 3, for example. Further, the communication device 184 may be a wireless LAN compatible communication device or a cable communication device that performs cable communication by wire.

Note that the information processing apparatus 1 or the information processing system controlled by the computer programs according to each embodiment of the present disclosure described above may be provided. Further, the storage medium that stores the computer programs according to each embodiment of the present disclosure may be provided. These are also included in the technical scope of the present disclosure.

### <7. Summary>

As described in details above, with the information processing apparatus controlled by the program according to one embodiment of the present disclosure, the user designs the object having an arbitrary shape and arranges the plants on the object, thereby enabling the designing of the garden. Further, the information processing apparatus evaluates the validity of the arrangement of the plants input by the user based on the influences exerted by respective plants on each other, thereby enabling the user to be assisted so as to design the garden having the plant arrangement with higher validity.

Further, the information processing apparatus generates the positional information for sowing the seeds of the plants based on the arrangement information of the plants arranged to the object, thereby enabling assisting of the planting of the seeds of the plants arranged to the object to the user.

Furthermore, the information processing apparatus designs the pipeline arrangement that supplies the water and nutrition required for the growth of the plants based on the arrangement information of the plants arranged to the object, thereby enabling assisting of the growth of the plants arranged to the object to the user.

In addition, the information processing apparatus optimizes the arrangement of the scenery elements arranged to the object, thereby enabling the assisting of the total design of the garden having the arrangement of the plants and the scenery elements on the object with an arbitrary shape to the user.

In addition, the information processing apparatus optimizes the environment on the object to the suitable environment for the survival of the specific living thing, thereby enabling the assisting of the design of the garden that is closer to the natural environment and is capable of calling various living things to the user.

Note that the above-mentioned second to fifth embodiments of the present disclosure may be mutually combined, and the combination is included in the technical scope of the present disclosure.

The preferred embodiment(s) of the present disclosure has/have been described above with reference to the accompanying drawings, whilst the present disclosure is not limited to the above examples. A person skilled in the art may find various alterations and modifications within the scope of the appended claims, and it should be understood that they will naturally come under the technical scope of the present disclosure.

Further, the effects described in this specification are merely illustrative or exemplified effects, and are not limitative. That is, with or in the place of the above effects, the technology according to the present disclosure may achieve other effects that are clear to those skilled in the art based on the description of this specification.

Additionally, the present technology may also be configured as below.
(1) A program for causing a computer to function as:
   a layout acquisition unit configured to acquire arrangement information of plants arranged on a landscape by a user;
   a vegetation information acquisition unit configured to acquire vegetation information relating to influences exerted by the respective plants on each other; and
   a validity evaluation unit configured to evaluate validity of an arrangement of the plants indicated by the arrangement information, based on the vegetation information.
(2) The program according to (1), wherein
   the validity evaluation unit evaluates the validity of the arrangement of the plants, further based on growth conditions of the plants.
(3) The program according to (1) or (2) for causing the computer to further function as:
   a modified plan generation unit configured to modify the arrangement of the plants arranged by the user and generate modified arrangement information of the plants, in a manner that evaluation of validity performed by the validity evaluation unit is higher.
(4) The program according to any one of (1) to (3), wherein
   the landscape is a shape of a culture medium input by a user.
(5) The program according to any one of (1) to (4) for causing the computer to further function as:
   a growth image generation unit configured to generate images representing a growth state of the plants, based on the arrangement information of the plants.
(6) The program according to any one of (1) to (5) for causing the computer to further function as:
   a sowing information generation unit configured to generate sowing information indicating a sowing position of seeds of the plants, based on the arrangement information of the plants.
(7) The program according to (6), wherein
   the sowing information generation unit generates the sowing information, further based on a germination rate of seeds of the plants.
(8) The program according to any one of (1) to (7) for causing the computer to further function as:
   a pipeline design unit configured to design a pipeline arrangement which supplies each of the plants with water and nutrition required for growth of the plants, based on the arrangement information of the plants.
(9) The program according to (8), wherein
   the pipeline design unit designs the pipeline arrangement, in a manner that the pipeline is a structure supporting a shape of the landscape.
(10) The program according to (8) or (9) for causing the computer to further function as:
   a nutrient solution calculation unit configured to calculate amount and frequency of water and nutrition to be poured into the pipeline, based on the arrangement information of the plants.
(11) The program according to any one of (1) to (10), wherein
   the layout acquisition unit further acquires arrangement information of scenery elements arranged on the landscape by the user.
(12) The program according to (11) for causing the computer to further function as:
   a scenery optimization unit configured to assist the user to optimize the arrangement of the scenery elements.
(13) The program according to any one of (1) to (12) for causing the computer to further function as:
   an environment evaluation unit configured to evaluate a degree as to whether or not the landscape where the plants are arranged is a suitable environment for survival of specific living things.
(14) The program according to (13) for causing the computer to further function as:
   an environment optimization unit configured to assist the user in a manner that the landscape where the plants are arranged is a more suitable environment for survival of the specific living things.
(15) An information processing system including:
   a layout acquisition unit configured to acquire arrangement information of plants arranged on a landscape by a user;
   a vegetation information acquisition unit configured to acquire vegetation information relating to influences exerted by the respective plants on each other; and
   a validity evaluation unit configured to evaluate validity of an input arrangement of the plants, based on the vegetation information.
(16) An information processing method including:
   acquiring arrangement information of plants arranged on a landscape by a user;
   acquiring vegetation information relating to influences exerted by the respective plants on each other; and
   evaluating, by an arithmetic operation processing unit, validity of an arrangement of the plants indicated by the arrangement information, based on the vegetation information.

### Reference Signs List

- 1A, 1B, 1C, 1D, 1E: information processing apparatus
- 100: input unit 100
- 102: layout acquisition unit
- 104: vegetation information acquisition unit
- 106: vegetation information storage unit
- 108: validity evaluation unit
- 110: modified plan generation unit
- 112: growth image generation unit
- 114: output unit
- 116: sowing information generation unit
- 118: pipeline design unit
- 120: nutrient solution calculation unit
- 122: scenery optimization unit
- 124: scenery information storage unit
- 126: environmental evaluation unit
- 128: environment optimization unit
- 130: living-things information storage unit

## Claims

1. A program for causing a computer to function as:
a layout acquisition unit configured to acquire arrangement information of plants arranged on a landscape by a user;
a vegetation information acquisition unit configured to acquire vegetation information relating to influences exerted by the respective plants on each other; and
a validity evaluation unit configured to evaluate validity of an arrangement of the plants indicated by the arrangement information, based on the vegetation information.

2. The program according to claim 1, wherein
the validity evaluation unit evaluates the validity of the arrangement of the plants, further based on growth conditions of the plants.

3. The program according to claim 1 for causing the computer to further function as:
a modified plan generation unit configured to modify the arrangement of the plants arranged by the user and generate modified arrangement information of the plants, in a manner that evaluation of validity performed by the validity evaluation unit is higher.

4. The program according to claim 1, wherein
the landscape is a shape of a culture medium input by a user.

5. The program according to claim 1 for causing the computer to further function as:
a growth image generation unit configured to generate images representing a growth state of the plants, based on the arrangement information of the plants.

6. The program according to claim 1 for causing the computer to further function as:
a sowing information generation unit configured to generate sowing information indicating a sowing position of seeds of the plants, based on the arrangement information of the plants.

7. The program according to claim 6, wherein
the sowing information generation unit generates the sowing information, further based on a germination rate of seeds of the plants.

8. The program according to claim 1 for causing the computer to further function as:
a pipeline design unit configured to design a pipeline arrangement which supplies each of the plants with water and nutrition required for growth of the plants, based on the arrangement information of the plants.

9. The program according to claim 8, wherein
the pipeline design unit designs the pipeline arrangement, in a manner that the pipeline is a structure supporting a shape of the landscape.

10. The program according to claim 8 for causing the computer to further function as:
a nutrient solution calculation unit configured to calculate amount and frequency of water and nutrition to be poured into the pipeline, based on the arrangement information of the plants.

11. The program according to claim 1, wherein
the layout acquisition unit further acquires arrangement information of scenery elements arranged on the landscape by the user.

12. The program according to claim 11 for causing the computer to further function as:
a scenery optimization unit configured to assist the user to optimize the arrangement of the scenery elements.

13. The program according to claim 1 for causing the computer to further function as:
an environment evaluation unit configured to evaluate a degree as to whether or not the landscape where the plants are arranged is a suitable environment for survival of specific living things.

14. The program according to claim 13 for causing the computer to further function as:
an environment optimization unit configured to assist the user in a manner that the landscape where the plants are arranged is a more suitable environment for survival of the specific living things.

15. An information processing system comprising:
a layout acquisition unit configured to acquire arrangement information of plants arranged on a landscape by a user;
a vegetation information acquisition unit configured to acquire vegetation information relating to influences exerted by the respective plants on each other; and
a validity evaluation unit configured to evaluate validity of an input arrangement of the plants, based on the vegetation information.

16. An information processing method comprising:
acquiring arrangement information of plants arranged on a landscape by a user;
acquiring vegetation information relating to influences exerted by the respective plants on each other; and
evaluating, by an arithmetic operation processing unit, validity of an arrangement of the plants indicated by the arrangement information, based on the vegetation information.
